(19) Europäisches Patentamt
European Patent Office
Office européen des brevets

(11) **EP 4 148 718 A1**

(12) **DEMANDE DE BREVET EUROPEEN**

(43) Date de publication:
**15.03.2023 Bulletin 2023/11**

(21) Numéro de dépôt: **22205316.7**

(22) Date de dépôt: **06.03.2018**

(51) Classification Internationale des Brevets (IPC):
**G09G 3/32** (2006.01)   **G06K 9/00** (2006.01)
**G06F 3/042** (2006.01)   **H01L 27/146** (2006.01)
**G06F 3/041** (2006.01)   **G09G 3/3208** (2016.01)
**H01L 27/32** (2006.01)   **H01L 27/30** (2006.01)
**G06V 10/10** (2022.01)   **G06V 40/12** (2022.01)
**G06V 40/13** (2022.01)

(52) Classification Coopérative des Brevets (CPC):
**G09G 3/3208; G06F 3/0428; G06V 10/17;
G06V 40/12; G06V 40/1318; H01L 27/14627;
H01L 27/14678; H10K 39/32; H10K 59/65;**
G06F 3/0412; G06F 3/042; G09G 2300/023;
G09G 2360/144

(84) Etats contractants désignés:
**AL AT BE BG CH CY CZ DE DK EE ES FI FR GB
GR HR HU IE IS IT LI LT LU LV MC MK MT NL NO
PL PT RO RS SE SI SK SM TR**

(30) Priorité: **06.03.2017 FR 1751789
11.08.2017 FR 1757669**

(62) Numéro(s) de document de la (des) demande(s)
initiale(s) en application de l'article 76 CBE:
**18712962.2 / 3 593 342**

(71) Demandeur: **ISORG
87068 Limoges Cedex 3 (FR)**

(72) Inventeurs:
• **SCHWARTZ, Wilfrid
38000 GRENOBLE (FR)**
• **PUSZKA, Agathe
38000 GRENOBLE (FR)**
• **CHABLE, Quentin
38000 GRENOBLE (FR)**
• **BOUTHINON, Benjamin
38000 GRENOBLE (FR)**

(74) Mandataire: **Cabinet Beaumont
4, Place Robert Schuman
B.P. 1529
38025 Grenoble Cedex 1 (FR)**

Remarques:
Cette demande a été déposée le 03-11-2022 comme
demande divisionnaire de la demande mentionnée
sous le code INID 62.

(54) **SYSTÈME D'ACQUISITION D'IMAGES**

(57)     L'invention concerne un système d'acquisition d'images (10) comprenant :
- une source (22) d'un rayonnement (44) ;
- un capteur d'images (14) comprenant une matrice de photodétecteurs adaptés à détecter ledit rayonnement et comprenant une face (15) ; et

- un filtre angulaire (16), recouvrant le capteur, et adapté à bloquer les rayons dudit rayonnement dont l'incidence par rapport à une direction orthogonale à la face est supérieure à un seuil et à laisser passer au moins certains rayons dudit rayonnement dont l'incidence par rapport à une direction orthogonale à la face est inférieure au seuil.

Fig 1

EP 4 148 718 A1

**Description**

La présente demande de brevet revendique la priorité des demandes de brevets français FR17/51789 et FR17/57669 qui seront considérées comme faisant partie intégrante de la présente description.

Domaine

La présente demande concerne un système d'acquisition d'images.

Exposé de l'art antérieur

Un système d'acquisition d'images comprend généralement un capteur d'images et un système optique, interposé entre la partie sensible du capteur d'images et l'objet à imager et qui permet de former une image nette de l'objet à imager sur la partie sensible du capteur d'images.

Toutefois, dans certains cas, il n'est pas possible de disposer un tel système optique entre la partie sensible du capteur d'images et l'objet à imager. C'est le cas notamment lorsque le capteur d'images occupe une surface importante, supérieure au centimètre carré et que la distance entre l'objet à imager et la partie sensible du capteur d'images est inférieure au centimètre.

Il faudrait alors placer l'objet à imager au plus près du capteur d'images pour que l'image qui se forme sur la partie sensible du capteur d'images soit suffisamment nette. Toutefois, une distance peut être présente entre l'objet et le capteur d'images de sorte que la netteté de l'image qui se forme sur la partie sensible du capteur d'images peut ne pas être suffisante pour certaines applications, par exemple pour la capture d'empreintes digitales.

Résumé

Un objet d'un mode de réalisation est d'accroître la netteté de l'image acquise par le capteur d'images d'un système d'acquisition d'images en l'absence de système optique formant une image nette de l'objet à imager sur la partie sensible du capteur d'images.

Un autre objet d'un mode de réalisation est que la surface de la partie sensible du capteur d'images est supérieure au centimètre carré.

Un autre objet d'un mode de réalisation est que la distance entre l'objet à imager et la partie sensible du capteur d'images est inférieure au centimètre.

Un autre objet d'un mode de réalisation est que la distance entre l'objet à imager et la partie sensible du capteur d'images est supérieure à cinquante micromètres.

Ainsi, un mode de réalisation prévoit un système d'acquisition d'images comprenant :

- une source d'un rayonnement ;
- un capteur d'images comprenant une matrice de photodétecteurs adaptés à détecter ledit rayonnement et comprenant une face ; et
- un filtre angulaire, recouvrant le capteur d'images, et adapté à bloquer les rayons dudit rayonnement dont l'incidence par rapport à une direction orthogonale à la face est supérieure à un seuil et à laisser passer des rayons dudit rayonnement dont l'incidence par rapport à une direction orthogonale à la face est inférieure au seuil.

Selon un mode de réalisation, le système comprend, en outre, un revêtement, au moins partiellement transparent audit rayonnement et recouvrant le capteur d'images, le filtre angulaire étant interposé entre le revêtement et le capteur d'images.

Selon un mode de réalisation, la source est adaptée à émettre ledit rayonnement dans le revêtement depuis la périphérie du revêtement, le revêtement jouant le rôle d'un guide d'onde pour ledit rayonnement.

Selon un mode de réalisation, le rayonnement est dans le domaine visible et/ou dans le domaine infrarouge.

Selon un mode de réalisation, le filtre angulaire comprend une matrice de trous délimités par des murs opaques audit rayonnement ou en un matériau polarisant, les trous étant remplis d'air ou d'un matériau au moins partiellement transparent audit rayonnement.

Selon un mode de réalisation, pour chaque trou, le rapport entre la hauteur du trou, mesurée perpendiculairement à la face, et la largeur du trou, mesurée parallèlement à la face, varie de 1 à 10.

Selon un mode de réalisation, les trous sont agencés en rangées et en colonnes, le pas entre des trous adjacents d'une même rangée ou d'une même colonne variant de 10 $\mu$m à 30 $\mu$m.

Selon un mode de réalisation, la hauteur de chaque trou, mesurée selon une direction orthogonale à la face, varie de 1 $\mu$m à 1 mm.

Selon un mode de réalisation, la largeur de chaque trou, mesurée parallèlement à la face, varie de 5 $\mu$m à 30 $\mu$m.

Selon un mode de réalisation, les murs sont en totalité en un matériau opaque audit rayonnement.

Selon un mode de réalisation, chaque mur comprend un coeur en un matériau transparent audit rayonnement recouvert d'une couche opaque audit rayonnement.

Selon un mode de réalisation, le système comprend, en outre, des lentilles recouvrant les trous.

Selon un mode de réalisation, le système comprend, pour chaque trou, une lentille recouvrant le trou et au contact des murs.

Selon un mode de réalisation, les photodétecteurs comprennent des photodiodes organiques.

Un mode de réalisation prévoit un système d'affichage comprenant le système d'acquisition d'images tel que défini précédemment et comprenant en outre un écran d'affichage, le filtre angulaire étant interposé entre l'écran d'affichage et le capteur d'images.

Selon un mode de réalisation, l'écran d'affichage comprend une matrice de composants électroluminescents et les photodétecteurs sont décalés par rapport aux composants électroluminescents selon une direction perpendiculaire à la face.

Selon un mode de réalisation, les composants électroluminescents sont séparés les uns des autres par des zones intermédiaires et les photodétecteurs sont situés dans le prolongement desdites zones intermédiaires selon une direction perpendiculaire à ladite face.

Selon un mode de réalisation, l'écran d'affichage comprend une matrice de composants électroluminescents, les composants électroluminescents sont au moins en partie transparents au rayonnement et les composants électroluminescents sont situés au moins en partie en regard des photodétecteurs selon une direction perpendiculaire à ladite face.

Selon un mode de réalisation, les composants électroluminescents comprennent des diodes électroluminescentes organiques.

Un mode de réalisation prévoit également l'utilisation du système d'affichage tel que défini précédemment pour la détection d'au moins une empreinte digitale d'un utilisateur.

Un mode de réalisation prévoit également un procédé de fabrication d'un système d'acquisition d'images, comprenant les étapes suivantes :

- fournir une source d'un rayonnement ;
- former un capteur d'images comprenant une matrice de photodétecteurs adaptés à détecter ledit rayonnement et comprenant une face ; et
- former un filtre angulaire, recouvrant le capteur d'images, et adapté à bloquer les rayons dudit rayonnement dont l'incidence par rapport à une direction orthogonale à la face est supérieure à un seuil et à laisser passer des rayons dudit rayonnement dont l'incidence par rapport à une direction orthogonale à la face est inférieure au seuil.

Selon un mode de réalisation, le filtre angulaire comprend une matrice de trous délimités par des murs opaques audit rayonnement, la formation du filtre angulaire comprenant les étapes suivantes :

former une couche d'une résine photosensible ; et
former les murs par gravure de la couche par photolithographie.

Selon un mode de réalisation, la résine photosensible est une résine noire ou colorée.

Selon un mode de réalisation, le filtre angulaire comprend une matrice de trous délimités par des murs opaques audit rayonnement, la formation du filtre angulaire comprenant les étapes suivantes :

formation d'un moule en résine transparente, par des étapes de photolithographie, de forme complémentaire de la forme souhaitée des murs ;
remplissage du moule par le matériau composant les murs ; et
retrait de la structure obtenue du moule.

Selon un mode de réalisation, le filtre angulaire comprend une matrice de trous délimités par des murs opaques audit rayonnement, chaque mur comprenant un coeur en un matériau transparent audit rayonnement recouvert d'une couche opaque audit rayonnement, la formation du filtre angulaire comprenant les étapes suivantes :

former une couche d'une résine photosensible transparente audit rayonnement ;
graver la couche par photolithographie selon la forme souhaitée des murs ; et
recouvrir la structure obtenue de la couche opaque audit rayonnement.

Selon un mode de réalisation, la formation du filtre angulaire comprend la perforation de trous de taille micrométrique dans un film noir ou coloré.

Selon un mode de réalisation, les trous sont percés au moyen d'aiguilles de taille micrométrique.

Brève description des dessins

Ces caractéristiques et avantages, ainsi que d'autres, seront exposés en détail dans la description suivante de modes de réalisation particuliers faite à titre non limitatif en relation avec les figures jointes parmi lesquelles :

les figures 1 et 2 sont des vues en coupe, partielles et schématiques, de modes de réalisation d'un système d'acquisition d'images ;

la figure 3 est une vue en coupe d'un mode de réalisation d'un capteur d'images du système d'acquisition d'images de la figure 2 ;

la figure 4 est une vue en coupe, partielle et schématique, d'un autre mode de réalisation d'un système d'acquisition d'images ;

les figures 5 et 6 sont des vues en coupe analogues à la figure 4 illustrant le fonctionnement du système d'acquisition d'images de la figure 4 utilisé comme capteur d'empreintes digitales ;

la figure 7 est une vue de dessus, partielle et schématique, d'un mode de réalisation d'un système d'affichage comprenant un écran d'affichage et un capteur d'images ;

les figures 8A et 8B sont respectivement une vue de dessus et une vue en coupe, partielles et schématiques, d'un mode de réalisation d'un système d'affichage comprenant un écran d'affichage et un capteur d'images ;

la figure 9 est une vue de dessus, partielle et schématique, d'un autre mode de réalisation d'un système d'affichage comprenant un écran d'affichage et un capteur d'images ;

les figures 10 et 11 sont respectivement une vue en coupe et une vue de dessus, partielles et schématiques, d'un mode de réalisation d'un filtre angulaire ; et

les figures 12 à 17 sont des vues en coupe, partielles et schématiques, d'autres modes de réalisation d'un filtre angulaire ;

la figure 18 est une vue de dessus, partielle et schématique, d'un autre mode de réalisation d'un système d'affichage comprenant un écran d'affichage et un capteur d'images ;

la figure 19 est une vue de dessus, partielle et schématique, d'un mode de réalisation plus détaillé du capteur d'images du système d'affichage de la figure 18 ; et

les figures 20 à 22 sont des vues en coupe, partielles et schématiques, de modes de réalisation d'un système d'affichage comprenant un écran d'affichage et un capteur d'images.

Description détaillée

Par souci de clarté, de mêmes éléments ont été désignés par de mêmes références aux différentes figures et, de plus, comme cela est habituel dans la représentation des circuits électroniques, les diverses figures ne sont pas tracées à l'échelle. Dans la description qui suit, lorsque l'on fait référence à des qualificatifs de position absolue, tels que les termes "avant", "arrière", "haut", "bas", "gauche", "droite", etc., ou relative, tels que les termes "dessus", "dessous", "supérieur", "inférieur", etc., il est fait référence à l'orientation des figures ou à un système d'acquisition d'images ou un système d'affichage dans une position normale d'utilisation. En outre, seuls les éléments utiles à la compréhension de la présente description ont été représentés et sont décrits. En particulier, l'utilisation faite des capteurs décrits ci-après n'a pas été détaillée et l'utilisation faite des systèmes d'affichage décrits ci-après comprenant un écran d'affichage et un capteur d'images n'a pas été détaillée. L'homme de l'art saura utiliser les systèmes d'affichage dans tout type de système susceptible d'être commandé via une interface tactile. En outre, la structure d'un système d'acquisition d'images ou d'un écran d'affichage est bien connue de l'homme du métier et ne sera pas décrite en détail par la suite. De plus, les moyens de traitement des signaux fournis par les systèmes d'acquisition d'images décrits ci-après sont à la portée de l'homme de l'art et ne seront pas décrits. Dans la suite de la description, sauf indication contraire, les termes "sensiblement", "environ" et "de l'ordre de" signifient "à 10 % près". Dans le cas d'un angle, sauf indication contraire, les termes "sensiblement" et "environ" signifient "à 10° près".

Dans la suite de la description, on appelle lumière visible un rayonnement électromagnétique dont la longueur d'onde est comprise entre 400 nm et 700 nm et on appelle rayonnement infrarouge un rayonnement électromagnétique dont la longueur d'onde est comprise entre 700 nm et 1 mm. Dans le rayonnement infrarouge, on distingue notamment le rayonnement infrarouge proche dont la longueur d'onde est comprise entre 700 nm et 1,4 $\mu$m.

Un pixel d'une image correspond à l'élément unitaire de l'image affichée par un écran d'affichage. Lorsque l'écran d'affichage est un écran d'affichage d'images couleur, il comprend en général pour l'affichage de chaque pixel de l'image au moins trois composants d'émission et/ou de régulation de l'intensité lumineuse, également appelés sous-pixels d'affichage, qui émettent chacun un rayonnement lumineux sensiblement dans une seule couleur (par exemple, le rouge, le vert et le bleu). La superposition des rayonnements émis par ces trois sous-pixels d'affichage fournit à l'observateur la sensation colorée correspondant au pixel de l'image affichée. On appelle dans ce cas pixel d'affichage de l'écran d'affichage l'ensemble formé par les trois sous-pixels d'affichage utilisés pour l'affichage d'un pixel d'une image.

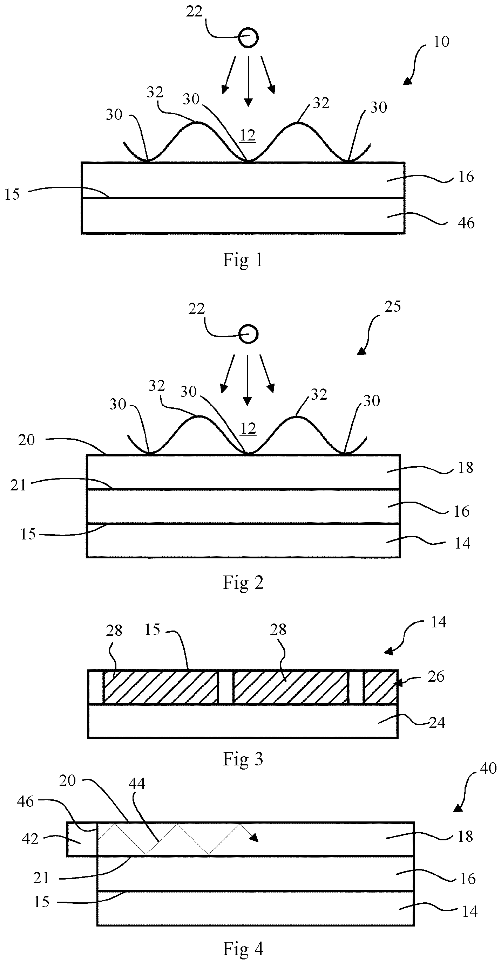

La figure 1 est une vue en coupe, partielle et schématique, d'un mode de réalisation d'un système d'acquisition d'images 10 d'un objet 12, partiellement représenté en figure 1. Le système d'acquisition d'images 10 comprend de bas en haut en figure 1 :

un capteur d'images 14 ayant une face supérieure 15 ;
un filtre angulaire 16 ; et
une source lumineuse 22.

Le système d'acquisition d'images 10 comprend, en outre, des moyens non représentés de traitement des signaux fournis par le capteur d'images 14, comprenant par exemple un microprocesseur.

La figure 2 est une vue en coupe, partielle et schématique, d'un autre mode de réalisation d'un système d'acquisition d'images 25 de l'objet 12. Le système d'acquisition d'images 25 comprend l'ensemble des éléments du système d'acquisition d'images 10 et comprend, en outre, un revêtement 18 ayant des faces supérieure et inférieure opposées 20, 21 recouvrant le filtre angulaire 16 du côté opposé au capteur d'images 14.

La figure 3 est une vue en coupe d'un mode de réalisation du capteur d'images 14. Le capteur d'images 14 comprend un support 24 et une matrice 26 de capteurs de photons 28, également appelés photodétecteurs, disposés entre le support 24 et le filtre angulaire 16. Les photodétecteurs 28 peuvent être recouverts d'un revêtement de protection transparent, non représenté. Le capteur d'images 14 comprend, en outre, des pistes conductrices et des éléments de commutation, notamment des transistors, non représentés, permettant la sélection des photodétecteurs 28. Les photodétecteurs 28 peuvent être réalisés en matériaux organiques. Les photodétecteurs 28 peuvent correspondre à des photodiodes organiques (OPD, de l'anglais Organic Photodiode) ou à des photorésistances organiques. La surface du capteur d'images 14 en regard du filtre angulaire 16 et contenant les photodétecteurs 28 est supérieure à 1 cm$^2$, de préférence supérieure à 5 cm$^2$, plus préférentiellement supérieure à 10 cm$^2$, en particulier supérieure à 20 cm$^2$. La face 15 peut être sensiblement plane.

Le revêtement 18 est au moins partiellement transparent au rayonnement émis par la source lumineuse 22. Le revêtement 18 peut avoir une épaisseur comprise en 1 µm et 10 mm. La face supérieure 20 et la face inférieure 21 peuvent être sensiblement planes.

Le filtre angulaire 16 est adapté à filtrer le rayonnement incident en fonction de l'incidence du rayonnement par rapport à la face supérieure 20 du filtre angulaire 16, notamment pour que chaque photodétecteur 28 reçoive seulement les rayons dont l'incidence par rapport à un axe perpendiculaire à la face supérieure 20 du filtre angulaire 16 est inférieure à un angle d'incidence maximale inférieur à 45°, de préférence inférieur à 30°, plus préférentiellement inférieur à 20°, encore plus préférentiellement inférieur à 10°. Le filtre angulaire 16 est adapté à bloquer les rayons du rayonnement incident dont l'incidence par rapport à un axe perpendiculaire à la face supérieure 20 du filtre angulaire 16 est supérieure à l'angle d'incidence maximale.

Dans le mode de réalisation représenté en figure 1 ou 2, l'objet 12 dont l'image est acquise par le capteur d'images 14 est interposé entre la source lumineuse 22 et le filtre angulaire 16 ou le revêtement 18. L'image est obtenue par transmission du rayonnement émis par la source lumineuse 22 à travers l'objet 12. Le rayonnement émis par la source 22 peut être un rayonnement visible et/ou un rayonnement infrarouge. Pour une application pour la détermination d'empreintes digitales, l'objet 12 correspond au doigt d'un utilisateur. De préférence, le doigt 12 est au contact de la face supérieure 20 du système d'acquisition d'images 10 de sorte que les rayons lumineux passant par des zones de contact 30 entre l'objet 12 et la face 20 sont fortement transmis tandis que les rayons lumineux traversant des zones hors contact 32, également appelées vallées, sont plus faiblement transmis. Les photodétecteurs 28 situés en regard des zones de contact 30 collectent la lumière diffusée à faible incidence tandis que les photodétecteurs 28 situés en regard des zones hors contact 32 collectent peu de lumière puisque celle-ci est pour l'essentiel bloquée par le filtre angulaire 16.

La figure 4 est une vue en coupe, partielle et schématique, d'un autre mode de réalisation d'un système d'acquisition d'images 40. Le système d'acquisition d'images 40 comprend l'ensemble des éléments du système d'acquisition d'images 25 représenté en figure 2 à la différence que la source lumineuse 22 est remplacée par une source lumineuse 42 adaptée à émettre un rayonnement lumineux 44 dans le revêtement 18 qui joue alors le rôle d'un guide d'ondes. Le rayonnement 44 émis par la source 42 peut être un rayonnement visible et/ou un rayonnement infrarouge. Le rayonnement 44 est injecté dans le revêtement 18 depuis la périphérie du revêtement 18. Dans le mode de réalisation représenté en figure 4, le rayonnement 44 est injecté dans le revêtement 18 depuis un bord latéral 46 du revêtement 18. Selon un autre mode de réalisation, le rayonnement 44 est injecté dans le revêtement 18 à la périphérie du revêtement 18 par la face supérieure 20 ou la face inférieure 21, de préférence par la face inférieure 21. Dans le présent mode de réalisation, le revêtement 18 a de préférence une épaisseur comprise entre 0,1 mm et 1 mm. Le revêtement 18 peut être en verre, ou en un matériau plastique.

Selon un mode de réalisation, le faisceau 44 émis par la source 42 et se propageant dans le revêtement 18 peut ne pas être collimaté. Selon un mode de réalisation, le faisceau 44 émis par la source 42 et se propageant dans le revêtement 18 est sensiblement collimaté, les rayons du faisceau 44 étant sensiblement parallèle aux faces 20, 21 du revêtement 18. Ceci peut permettre d'améliorer l'homogénéité de l'image des zones de contact 30 acquise par le capteur d'images 14.

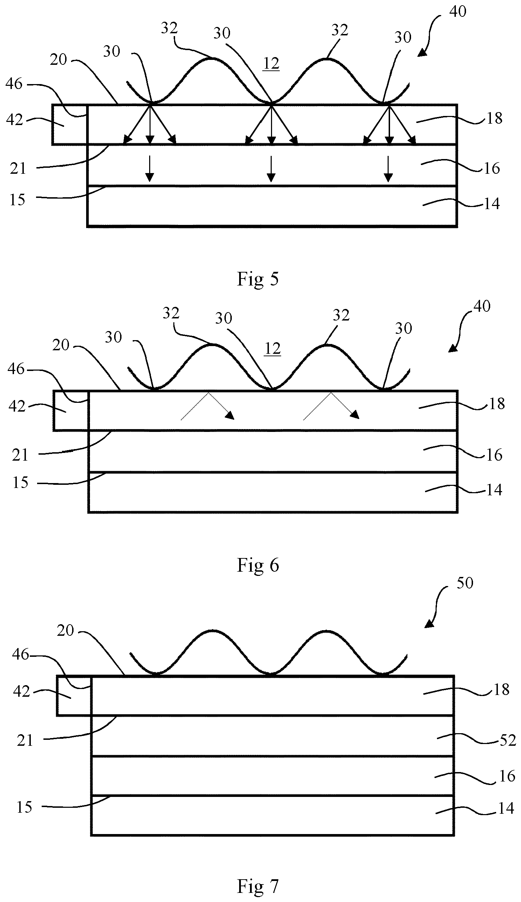

Les figures 5 et 6 illustrent le fonctionnement du système d'acquisition d'images 40 comme capteur d'empreintes digitales. Comme cela est représenté en figure 5, le rayonnement qui se propage dans le revêtement 18 est diffusé au niveau des zones de contact 30 entre l'objet 12 et la face supérieure 20 de sorte que les photodétecteurs 28 du capteur d'images 14 en regard des zones de contact reçoivent le rayonnement diffusé filtré par le filtre angulaire 16. Comme cela est représenté en figure 6, le rayonnement qui se propage dans le revêtement 18 reste confiné dans le revêtement 18 au niveau des vallées 32 de sorte que les photodétecteurs 28 du capteur d'images 14 en regard des vallées 32 reçoivent peu ou pas de rayonnement.

Un autre exemple d'application du système d'acquisition d'images 10 ou 40 concerne l'acquisition d'image d'une matière biologique au travers d'un support transparent dans lequel est placé la matière biologique, par exemple une culture biologique placée dans une boîte de Pétri.

La figure 7 est une vue en coupe, partielle et schématique, d'un mode de réalisation d'un système d'affichage 50.

Le système d'affichage 50 comprend l'ensemble des éléments du système d'acquisition d'image 40 représenté en figure 4 et comprend, en outre, un écran d'affichage 52 interposé entre le revêtement 18 et le filtre angulaire 16. La matrice des composants électroluminescents 56 est disposée dans un plan parallèle à la matrice de photodétecteurs 28. La matrice de photodétecteurs 28 et la matrice de composants électroluminescents 56 sont superposées avec interposition du filtre angulaire 16.

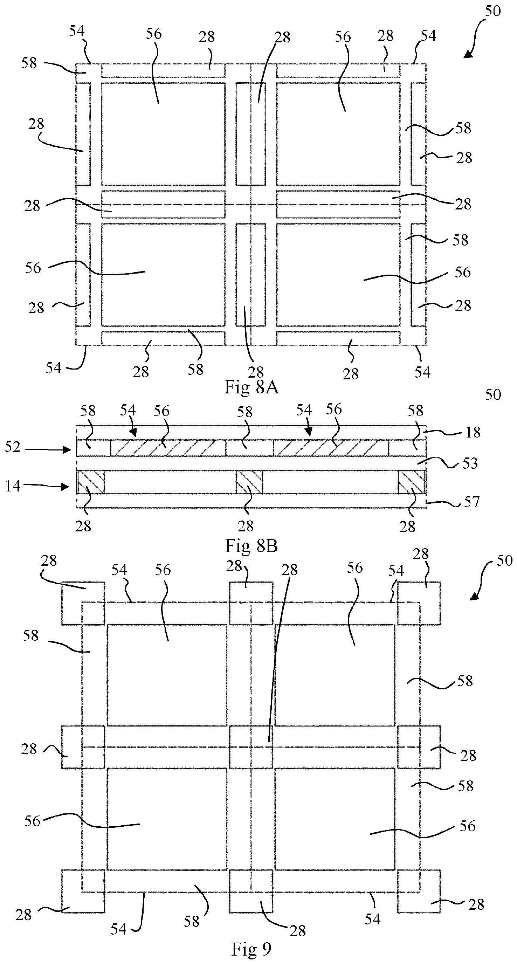

Les figures 8A et 8B sont respectivement une vue de dessus et une vue en coupe, partielles et schématiques, d'un mode de réalisation plus détaillé du système d'affichage 50.

La figure 9 est une vue de dessus, partielle et schématique, d'un autre mode de réalisation d'un système d'affichage comprenant un écran d'affichage et un capteur d'images. Le capteur d'images 14 repose sur un support 53.

L'écran d'affichage 52 comprend un premier support 53 et une matrice de sous-pixels d'affichage 54 sur le support 53.

L'écran d'affichage 52 comprend une matrice de sous-pixels d'affichage 54, représentés seulement sur les figures 8A et 9. Chaque sous-pixel d'affichage 54 comprend un composant optoélectronique 56 adapté à émettre un rayonnement électromagnétique, appelé composant électroluminescent dans la suite de la description. Chaque composant électroluminescent 56 correspond par exemple à une diode électroluminescente, notamment à une diode électroluminescente organique (OLED, de l'anglais Organic Light-Emitting Diode). Les sous-pixels d'affichage 54 peuvent, en outre, comprendre des pistes conductrices et des éléments de commutation, notamment des transistors, non représentés, permettant la sélection des sous-pixels d'affichage.

Le capteur d'images 14 comprend un deuxième support 57 et une matrice de capteurs de photons, ou photodétecteurs 28, disposés entre le support 57 et le support 53. Le filtre angulaire 16 non représenté en figure 8B est interposé entre le capteur d'images 14 et l'écran d'affichage 52. Les photodétecteurs 26 peuvent être recouverts d'un revêtement de protection transparent, non représenté. Le capteur d'images 14 comprend, en outre, des pistes conductrices et des éléments de commutation, notamment des transistors, non représentés, permettant la sélection des photodétecteurs 28.

Sur les figures 8A et 9, chaque sous-pixel d'affichage 54 est représenté de forme carrée et chaque composant électroluminescent 56 correspond à un empilement de couches ayant une forme sensiblement carrée. Toutefois, il est clair que la forme du sous-pixel d'affichage 54 et la forme du composant électroluminescent 56 peuvent être différentes, par exemple polygonale. Dans le présent mode de réalisation, en vue de dessus, la surface occupée par le composant électroluminescent 56 est inférieure à la surface du sous-pixel d'affichage 54 et chaque sous-pixel d'affichage 54 comprend une zone intermédiaire 58 entourant au moins en partie le composant électroluminescent 56. Sur les figures 8A, 8B et 9, le filtre angulaire 16 n'est pas représenté.

Le système d'affichage 50 comprend, en outre, des moyens non représentés de traitement des signaux fournis par le capteur d'images 14, comprenant par exemple un microprocesseur, et des moyens non représentés de commande de l'écran d'affichage 52.

La matrice des composants électroluminescents 56 est disposée dans un plan parallèle à la matrice de photodétecteurs 28. La matrice de photodétecteurs 28 et la matrice de composants électroluminescents 56 sont superposées avec interposition du filtre angulaire 16.

Selon un mode de réalisation, il peut être prévu un léger décalage entre les positions des composants électroluminescents 56 et les photodétecteurs 28 de façon que, en vue de dessus, les composants électroluminescents 56 ne soient pas en totalité ou en partie en regard des photodétecteurs 28, pour ne pas masquer les photodétecteurs 28.

Ce mode de réalisation est adapté au cas où les composants électroluminescents 56 ne sont pas transparents pour le rayonnement détecté par le capteur d'images 14 et que les zones intermédiaires 58 entourant les composants électroluminescents 56 laissent au moins partiellement passer la lumière visible et/ou la lumière infrarouge avec une transmittance supérieure à 5 %. Selon un mode de réalisation, les photodétecteurs 28 sont situés, en vue de dessus, entre les composants électroluminescents 56 de pixels adjacents.

Dans l'agencement représenté en figure 8A, chaque photodétecteur 28 s'étend, en vue de dessus, le long du bord commun entre deux sous-pixels d'affichage 54 adjacents. Dans l'agencement représenté en figure 9, chaque photodétecteur 28 est situé, en vue de dessus, au coin commun entre quatre sous-pixels d'affichage 54 adjacents.

Selon un mode de réalisation, la totalité de l'écran d'affichage 52 peut présenter une transmittance faible dans le domaine visible. Cela peut être le cas lorsque l'écran d'affichage 52 est un écran à cristaux liquide comprenant un réflecteur en face arrière d'une unité de rétroéclairage. Cela peut aussi être le cas pour certains types d'écrans OLED. Le rayonnement 44 émis par la source 42 peut alors être dans une plage de fréquences en dehors du domaine visible pour laquelle l'écran d'affichage 52 est au moins partiellement transparent, par exemple dans l'infrarouge.

Selon un autre mode de réalisation, dans le cas où les composants électroluminescents 56 sont au moins en partie transparents au rayonnement capté par les photodétecteurs 28, les composants électroluminescents 56 peuvent être situés, en vue de dessus, en partie ou en totalité en regard des photodétecteurs 28.

Dans le mode de réalisation représenté sur la figure 7, le rayonnement détecté par le capteur d'images 14 est celui fourni par la source 42 et peut être dans une plage de longueurs d'onde différente du rayonnement émis par l'écran d'affichage 52. Selon le mode de réalisation représenté en figure 8B, la source 42 n'est pas présente. Dans ce cas, le rayonnement détecté par le capteur d'images peut correspondre au rayonnement émis par les composants électroluminescents 56 de l'écran d'affichage 52 ou par certains d'entre eux. En particulier, pour l'application de capture d'empreintes digitales, l'écran d'affichage 52 peut émettre un rayonnement qui se réfléchit sur l'objet 12, le rayonnement réfléchi étant filtré angulairement par le filtre angulaire 16 et détecté par le capteur d'images 14. Selon un mode de réalisation, pour l'application de capture d'empreintes digitales, seuls des composants électroluminescents 56 de l'écran d'affichage 52 émettant la même couleur, par exemple la lumière bleue, sont activés.

Le pas entre des photodétecteurs 28 d'une même rangée ou d'une même colonne correspond sensiblement au pas des sous-pixels d'affichage 54 et est supérieur à 200 dpi, de préférence compris entre 250 dpi et 2000 dpi, plus préférentiellement compris entre 300 dpi et 2000 dpi.

Selon un mode de réalisation, chaque photodétecteur 28 est adapté à détecter un rayonnement électromagnétique dans une plage de longueurs d'ondes comprises entre 400 nm et 1100 nm. Les photodétecteurs 28 peuvent être adaptés à détecter un rayonnement électromagnétique dans la même plage de longueurs d'ondes. A titre de variante, les photodétecteurs 28 peuvent être adaptés à détecter un rayonnement électromagnétique dans des plages de longueurs d'ondes différentes.

Le capteur d'images 14 est utilisé pour détecter un organe d'actionnement, non représenté, par exemple un doigt ou un stylet, situé sur la couche de protection 18. Selon un mode de réalisation, on utilise l'image de l'organe d'actionnement vue par les photodétecteurs 28. Selon un mode de réalisation, l'image de l'organe d'actionnement est notamment formée par la réflexion, sur l'organe d'actionnement, du rayonnement lumineux émis par les sous-pixels d'affichage 54, en particulier les sous-pixels d'affichage 54 qui sont recouverts par l'organe d'actionnement. Selon un autre mode de réalisation, l'image de l'organe d'actionnement est obtenue à partir de la détection d'un autre rayonnement électromagnétique que le rayonnement émis par les sous-pixels d'affichage 54, notamment à partir de la détection d'un rayonnement infrarouge.

Selon un mode de réalisation, le capteur d'images 14 peut être utilisé pour détecter l'empreinte digitale d'au moins un doigt d'un utilisateur. De préférence, le capteur d'images 14 peut être utilisé pour détecter simultanément les empreintes digitales de plusieurs doigts de l'utilisateur. Selon un mode de réalisation, le capteur d'images 14 peut jouer le rôle d'une surface tactile, le système d'affichage 50 pouvant alors être utilisé comme interface utilisateur interactive contrôlable par simple glissement du doigt ou de la main sur la surface tactile. Une telle interface utilisateur interactive peut être utilisée notamment pour commander des téléphones mobiles, des ordinateurs, des postes de télévision, des véhicules automobiles, des billetteries automatiques, des équipements industriels, des équipements médicaux, etc.

De façon connue, chaque composant électroluminescent 56 peut comprendre un empilement de couches, comprenant notamment, entre deux électrodes, une couche de transport de trous (HTL), une couche d'émission (EML) et une couche de transport d'électrons (ETL). En appliquant une tension électrique appropriée, des électrons et des trous sont injectés dans la couche EML à partir des électrodes. Les électrons et les trous se recombinent dans la couche EML entraînant la libération de photons.

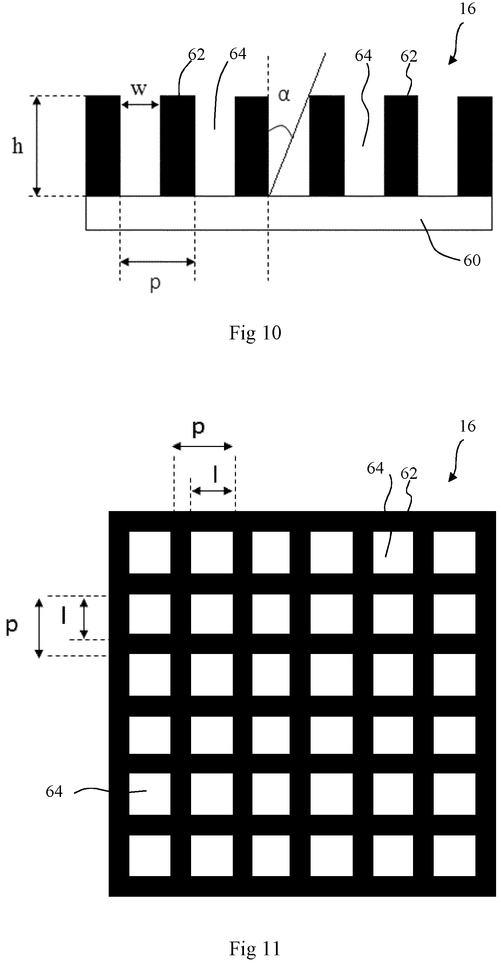

Les figures 10 et 11 sont respectivement une vue en coupe et une vue de dessus, partielles et schématiques, d'un mode de réalisation du filtre angulaire 16.

Dans le présent mode de réalisation, le filtre angulaire 16 comprend un support 60 et des murs 62 reposant sur le support 60 et délimitant des trous 64. On appelle "h" la hauteur des murs 64 mesurée depuis le support 60. Le support 60 est en un matériau au moins partiellement transparent au rayonnement capté par les photodétecteurs 28.

Les murs 62 sont opaques au rayonnement détecté par les photodétecteurs 28, par exemple absorbants et/ou réfléchissants par rapport au rayonnement détecté par les photodétecteurs 28. Selon un mode de réalisation, les murs 62 sont absorbants dans le visible et/ou le proche infrarouge et/ou l'infrarouge.

En figure 10, les trous 64 sont représentés avec une section droite carrée. De façon générale, la section droite des trous 64 dans la vue de dessus peut être circulaire, ovale ou polygonale, par exemple triangulaire, carrée ou rectangulaire.

Selon un mode de réalisation, les trous 64 sont disposés en rangées et en colonnes. Les trous 64 peuvent avoir sensiblement les mêmes dimensions. On appelle "w" la largeur d'un trou 64 mesurée selon la direction des rangées ou des colonnes. Selon un mode de réalisation, les trous 64 sont disposés régulièrement selon les rangées et selon les colonnes. On appelle "p" le pas de répétition des trous 64, c'est-à-dire la distance en vue de dessus des centres de deux trous 64 successifs d'une rangée ou d'une colonne.

Le filtre angulaire 16 représenté sur les figures 10 et 11 laisse seulement passer les rayons du rayonnement incident dont l'incidence par rapport au support 60 est inférieure à un angle d'incidence maximale $\alpha$, qui est défini par la relation (1) suivante :

$$\tan \alpha = w/h \qquad\qquad\qquad\qquad (1)$$

Plus le rapport w/h est petit, plus l'angle d'incidence maximale $\alpha$ est petit. La transmittance à incidence nulle du filtre angulaire 16 est proportionnelle au rapport entre la surface transparente en vue de dessus et la surface absorbante du filtre angulaire 16. Pour des applications à faible niveau de lumière, il est souhaitable que la transmittance soit maximale pour augmenter la quantité de lumière collectée par le capteur d'images 14. Pour des applications à fort niveau de lumière, la transmittance peut être diminuée afin de ne pas éblouir le capteur d'images 14.

Selon un mode de réalisation, les photodétecteurs 28 peuvent être répartis en rangées et en colonnes. Selon un mode de réalisation, le pas p des trous 64 est plus petit que le pas des photodétecteurs 28 du capteur d'image 14. Dans ce cas, plusieurs trous 64 peuvent se trouver en regard d'un photodétecteur 28. Selon un mode de réalisation, le pas p des trous 64 est identique au pas des photodétecteurs 28 du capteur d'image 14. Le filtre angulaire 16 est alors de préférence aligné avec le capteur d'images 14 de façon que chaque trou 64 soit en regard d'un photodétecteur 28. Selon un mode de réalisation, le pas p des trous 64 est plus grand que le pas des photodétecteurs 28 du capteur d'image 14. Dans ce cas, plusieurs photodétecteurs 28 peuvent se trouver en regard d'un trou 64.

Le rapport h/w peut varier de 1 à 10. Le pas p peut varier de 10 $\mu$m à 30 $\mu$m, par exemple environ 15 $\mu$m. La hauteur h peut varier de 1 $\mu$m à 1 mm, de préférence de 20 $\mu$m à 100 $\mu$m. La largeur w peut varier de 5 $\mu$m à 30 $\mu$m, par exemple environ 10 $\mu$m.

Le substrat 60 peut être en un polymère transparent, notamment en poly(téréphtalate d'éthylène) PET, poly(méthacrylate de méthyle) PMMA, polymère d'oléfine cyclique (COP). L'épaisseur du substrat 60 peut varier de 1 à 100. Le substrat 60 peut correspondre à un filtre coloré, à un polariseur, à une lame demi-onde ou à une lame quart d'onde. Le support 60 peut en outre correspondre au capteur d'images 14 ou à une couche de protection recouvrant le capteur d'images 14.

Les trous 64 peuvent être remplis d'air ou remplis d'un matériau au moins partiellement transparent au rayonnement détecté par les photodétecteurs 28, par exemple du polydiméthylsiloxane (PDMS). A titre de variante, les trous 64 peuvent être remplis par un matériau partiellement absorbant afin de filtrer chromatiquement les rayons filtrés angulairement par le filtre angulaire 16. Le filtre angulaire 16 peut alors jouer en outre le rôle d'un filtre coloré. Ceci permet de réduire l'épaisseur du système par rapport au cas où un filtre coloré distinct du filtre angulaire 16 serait présent. Le matériau de remplissage partiellement absorbant peut être une résine coloré ou un matériau plastique coloré comme le PDMS.

Le matériau de remplissage des trous 64 peut être adapté afin d'avoir une adaptation d'indice de réfraction avec la couche supérieure en contact avec le filtre angulaire 16 ou bien pour rigidifier la structure et améliorer la tenue mécanique du filtre angulaire 16.

Dans le mode de réalisation illustré sur les figures 10 et 11, les murs 62 sont en totalité en un matériau absorbant au moins pour les longueurs d'onde à filtrer angulairement. Les murs 62 peuvent être en résine colorée, par exemple une résine SU-8 colorée ou noire. A titre d'exemple, les murs 62 peuvent être en une résine noire absorbant dans le domaine visible et le proche infrarouge. Selon un autre exemple, les murs 62 peuvent être en résine colorée absorbant la lumière visible d'une couleur donnée, par exemple la lumière bleue, dans le cas où la source 42 émet de la lumière de couleur donnée, dans le cas où la source 42 est polychromatique et que le capteur d'images 14 est sensible seulement à la lumière de couleur donnée ou dans le cas où la source 42 est polychromatique, que le capteur d'images 14 est sensible à la lumière visible et qu'un filtre de la couleur donnée est interposé entre le filtre angulaire 16 et l'objet à détecter.

Un mode de réalisation d'un procédé de fabrication du filtre angulaire 16 représenté sur les figures 10 et 11 comprend les étapes suivantes :

dépôt d'une couche de résine colorée sur le support 60 dont l'épaisseur est sensiblement égale à la hauteur h ;
impression des motifs des murs 62 dans la couche de résine par photolithographie ; et
développement de la couche de résine pour ne conserver que les murs 62.

Un autre mode de réalisation d'un procédé de fabrication du filtre angulaire 16 représenté sur les figures 10 et 11 comprend les étapes suivantes :

formation d'un moule en résine transparente, par des étapes de photolithographie, de forme complémentaire de la forme souhaitée des murs 62 ;
remplissage du moule par le matériau composant les murs 62 ; et
retrait de la structure obtenue du moule.

Un autre mode de réalisation d'un procédé de fabrication du filtre angulaire 16 représenté sur les figures 10 et 11 comprend la perforation d'un film coloré d'épaisseur h, par exemple un film en PDMS, PMMA, PEC, COP. La perforation peut être réalisée en utilisant un outil de micro-perforation comprenant par exemple des micro-aiguilles pour obtenir les dimensions des trous 64 et le pas des trous 64 souhaités.

Selon un mode de réalisation, le filtre angulaire 16 est formé directement sur le capteur d'images 14, le support 60 pouvant alors correspondre au capteur d'images 14 ou à une couche de protection recouvrant le capteur d'images. Selon un autre mode de réalisation, le filtre angulaire 16 est formé séparément du capteur d'images 14. Le filtre angulaire 16 est alors fixé ultérieurement au capteur d'images 14, par exemple par laminage. L'épaisseur du substrat 60 est alors de préférence inférieure à 50 $\mu$m, et le substrat 60 est au moins partiellement transparent aux longueurs d'onde d'intérêt à mesurer par le capteur d'images 14.

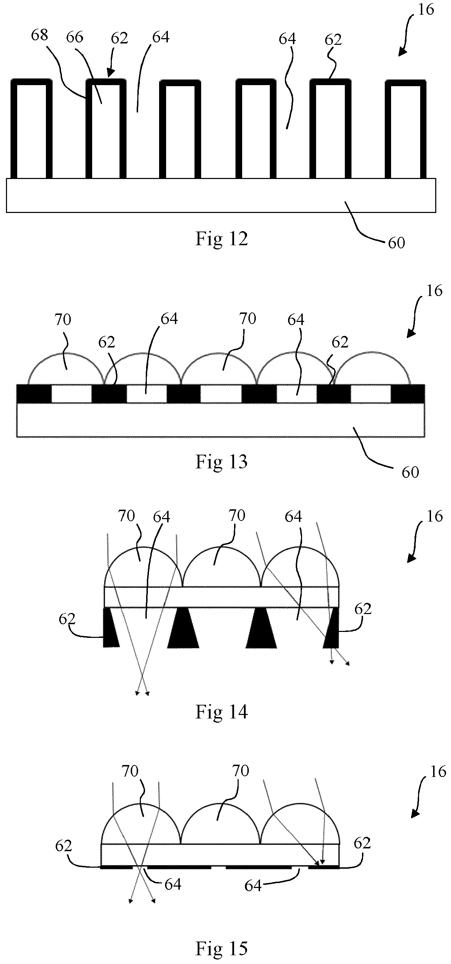

La figure 12 est une vue en coupe, partielle et schématique, d'une variante de réalisation des murs 62 du filtre angulaire 16 représenté sur les figures 10 et 11 dans laquelle chaque mur 62 comprend un coeur 66 en un premier matériau au moins en partie transparent au rayonnement détecté par le capteur d'images 14 et recouvert d'une couche 68 opaque au rayonnement détecté par les photodétecteurs 28, par exemple absorbante et/ou réfléchissante par rapport au rayonnement détecté par les photodétecteurs 28. Le premier matériau peut être une résine. Le deuxième matériau peut être un métal, par exemple de l'aluminium (Al) ou du chrome (Cr), un alliage métallique ou un matériau organique.

Un mode de réalisation d'un procédé de fabrication du filtre angulaire 16 représenté sur les figures 10 et 11 comprend les étapes suivantes :

dépôt d'une couche de résine transparente sur le support 60, par exemple par dépôt à la tournette ou par revêtement par filière (en anglais slot die coating) ;
impression des motifs des murs 62 dans la couche de résine par photolithographie ;
développement de la couche de résine pour ne conserver que les coeurs 66 des murs 62 ; et
formation de la couche 68 sur les coeurs 66, notamment par un dépôt sélectif, par exemple par évaporation, du deuxième matériau seulement sur les coeurs 66, ou par dépôt d'une couche du deuxième matériau sur les coeurs 66 et sur le support 60 entre les coeurs 66 et par retrait du deuxième matériau présent sur le support 60.

La figure 13 est une vue en coupe, partielle et schématique, d'un autre mode de réalisation du filtre angulaire 16. Le filtre angulaire 16 comprend la structure représentée sur les figures 10 et 11 et comprend, en outre, pour chaque trou 64, une microlentille 70 reposant sur les sommets des murs 62 et recouvrant le trou 64.

Chaque microlentille 70 permet de façon avantageuse d'augmenter la collection de rayons du rayonnement incident dont l'incidence est inférieure à un angle d'incidence maximale souhaité mais qui seraient bloqués par les parois des murs 62 en l'absence de la microlentille 70. Un tel mode de réalisation est particulièrement adapté aux applications dans lesquelles le niveau de lumière est faible, comme la capture d'empreintes digitales à travers l'écran d'affichage 52. Les microlentilles 70 peuvent être réalisées en silice ou en PMMA. Le matériau de remplissage des trous 64 peut être le même que le matériau composant les microlentilles 70.

Le pas des microlentilles 70 peut être le même que le pas des photodétecteur 28 ou plus petit. En présence de microlentilles 70, les trous 64 du filtre angulaire 16 agissent essentiellement comme un micro-diaphragme optique entre les microlentilles 70 et le capteur d'images 14 de sorte qu'il y a moins de contrainte sur le rapport de forme w/h des trous 64 par rapport au cas où les microlentilles 70 ne sont pas présentes. L'angle d'incidence maximale est déterminé par la largeur w des trous 64 et la courbure des microlentilles 70.

La figure 14 est une vue en coupe, partielle et schématique, d'une variante du mode de réalisation représenté en figure 13 dans laquelle la section droite des trous 64 n'est pas constante, la section droite diminuant au fur et à mesure que l'on s'éloigne des microlentilles 70.On a représenté, en partie gauche de la figure 14, des rayons lumineux en incidence normale qui ne sont pas bloqués par le filtre angulaire 16 et, en partie droite de la figure 14, des rayons lumineux en incidence oblique qui sont bloqués par le filtre angulaire 16.

La figure 15 est une vue en coupe, partielle et schématique, d'une variante du mode de réalisation représenté en figure 13 dans laquelle les murs 62 sont formés dans une couche mince située sensiblement au niveau du plan focal des microlentilles de sorte que chaque trou 64 est centré sensiblement sur le foyer de la microlentille 70 associée. On a représenté, en partie gauche de la figure 15, des rayons lumineux en incidence normale qui ne sont pas bloqués par le filtre angulaire 16 et, en partie droite de la figure 15, des rayons lumineux en incidence oblique qui sont bloqués par le filtre angulaire 16. Cet agencement d'ouvertures au (ou près du) plan focal permet de maintenir la sélectivité angulaire du filtre sans diminuer la sensibilité effective du pixel par une réduction de sa surface active.

Un mode de réalisation d'un procédé de fabrication du filtre angulaire 16 représenté sur la figure 14 ou 15 comprend les étapes suivantes :

formation des microlentilles sur la face supérieure d'un support transparent, notamment par des techniques d'impression ;
formation d'une couche d'une résine photosensible positive sur la face inférieure du support ; et
formation des trous 64 dans la couche par exposition de la résine photosensible par une lumière collimatée à travers le masque constitué par le réseau de microlentilles 70 et retrait des portions exposées de la résine.

Ce procédé de réalisation permet d'aligner automatiquement les microlentilles 70 avec les trous 64.

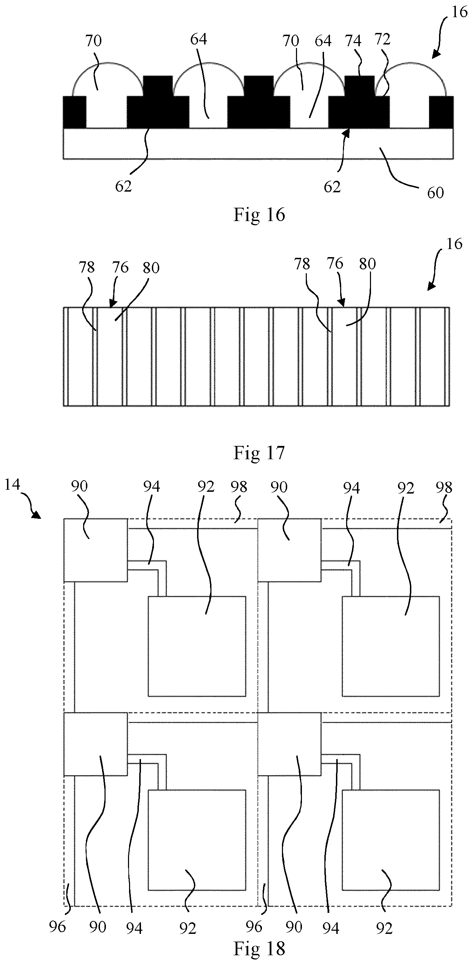

La figure 16 est une vue en coupe, partielle et schématique, d'une variante du mode de réalisation représenté en figure 13 dans laquelle les murs 62 comprennent des rebords 72 sur lesquels reposent les microlentilles 70 et comprennent des portions d'extrémité 74 qui s'étendent depuis les rebords 72 entre les microlentilles 70. Ceci permet de réduire la diaphonie entre microlentilles 70 voisines.

La figure 17 est une vue en coupe, partielle et schématique, d'un autre mode de réalisation du filtre angulaire 16 dans lequel le filtre angulaire 16 comprend une plaque de fibres optiques. La plaque de fibres optiques comprend des fibres optiques 76 dont les axes optiques sont sensiblement parallèles et orientés parallèlement à l'axe des rayons d'incidence nulle détectés par le capteur d'images 14. Le coeur 78 de chaque fibre optique 76 est un premier matériau transparent pour le rayonnement détecté par le capteur d'images 74. La gaine 80 de chaque fibre optique 76 entoure le coeur 78 et est en un matériau ayant un indice de réfraction inférieur à celui du coeur 78. Les gaines 78 des fibres optiques 76 peuvent former une structure monobloc.

La figure 18 est une vue de dessus d'un mode de réalisation plus détaillé du capteur d'images 14 dans lequel chaque photodétecteur 28 correspond à une photodiode et dans lequel le capteur d'images 14 comprend un élément de sélection 90 associé à chaque photodiode 28.

L'élément de sélection 90 peut correspondre à un transistor, par exemple un transistor en silicium amorphe, un transistor en silicium polycristallin à faible température (LTPS, sigle anglais pour Low-Temperature Polycrystalline Silicon), un transistor à base d'oxyde d'indium, de gallium et de zinc (IGZO) ou un transistor organique à effet de champ (en anglais Organic Field Effect Transistor ou OFET), notamment un transistor organique en couche mince (en anglais Organic Thin Film Transistor ou OTFT).

L'une des bornes parmi la source et le drain du transistor 90 est connectée à une électrode inférieure 92 de la photodiode par un élément de connexion 94 et l'autre borne parmi la source et le drain est connectée à une piste conductrice 96. Chaque piste conductrice 96 peut être connectée à tous les transistors 90 d'une même colonne. La grille de chaque transistor 90 peut être commandée par un signal transmis par une piste conductrice 98. Chaque piste conductrice 98 peut être connectée à tous les transistors 90 d'une même rangée.

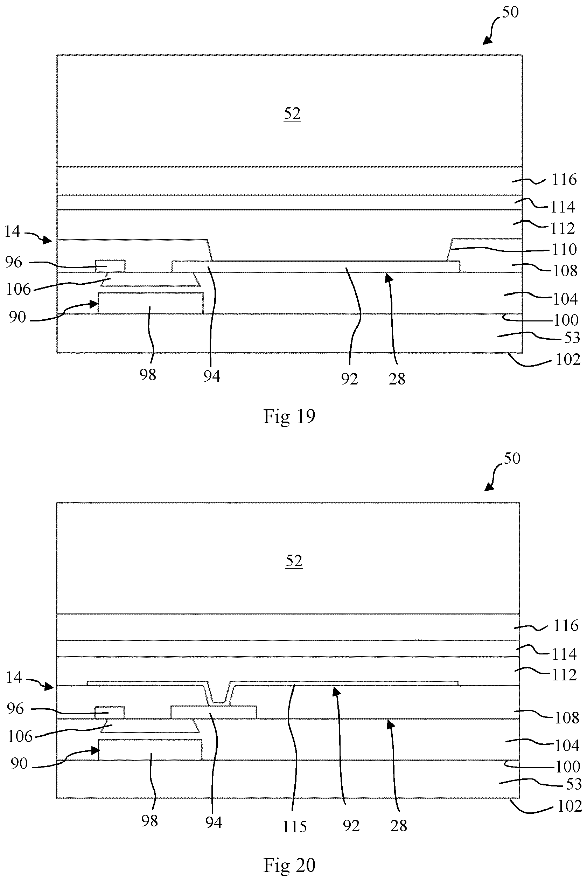

La figure 19 est une vue en coupe d'un mode de réalisation plus détaillé du système d'affichage 50 comprenant le capteur d'images 14 représenté en figure 18. Seul un photodétecteur 28 et l'élément de sélection 90 associé sont représentés en figure 19. L'écran d'affichage 52 n'est pas représenté en détail en figure 19.

Le capteur d'images 14 comprend successivement du bas vers le haut en figure 19 :

le support 53 comprenant deux faces 100, 102 opposées ;
la piste 98 reposant sur la face 100 du support 53 ;
un empilement 104 de couches isolantes recouvrant notamment la piste 98 ;
une portion semiconductrice 106, dans laquelle sont formées les régions de drain et de source du transistor 90, séparée de la piste 98 associée par l'empilement 104 de couches isolantes ;
l'élément de connexion 94 et la piste conductrice 96 s'étendant sur l'empilement 104 de couches isolantes ;
une couche isolante électriquement 108 recouvrant la portion semiconductrice 106 et la piste conductrice 96 et comprenant une ouverture 110 exposant une partie de l'élément de connexion 94 ;
une couche active 112 recouvrant la couche isolante 108 et au contact de l'élément de connexion 94 au travers de l'ouverture 110, la portion de l'élément de connexion 94 en contact avec la couche active 112 formant l'électrode inférieure 92 du photodétecteur 28 ;
une couche conductrice électriquement 114 recouvrant la couche active 112 et formant l'électrode supérieure du photodétecteur 28 ; et

une couche adhésive 116 recouvrant la couche conductrice électriquement 114.

Le filtre angulaire n'est pas représenté en figure 19.

Dans le présent mode de réalisation, la couche active 112 et l'électrode supérieure 114 sont communes à l'ensemble des photodétecteurs 28. La zone active de chaque photodétecteur 28 qui correspond à la zone dans laquelle la majorité du rayonnement incident est absorbée et convertie en signal électrique par le photodétecteur 28 correspond sensiblement à la partie de la couche active 112 située entre l'électrode inférieure 92 et l'électrode supérieure 114.

Le support 57 peut être en un matériau diélectrique. Le support 57 est, par exemple, un support rigide, notamment en verre ou un support flexible, par exemple en polymère ou en un matériau métallique. Des exemples de polymères sont le polyéthylène naphtalène (PEN), le polyéthylène téréphtalate (PET), le polyimide (PI), et le polyétheréthercétone (PEEK). L'épaisseur du support 57 est, par exemple, comprise entre 20 $\mu$m et 1 cm, par exemple environ 125 $\mu$m.

Les pistes conductrices 96, 98 et l'élément de connexion 94 peuvent être en un matériau métallique. Les pistes conductrices 96, 98 et l'élément de connexion 94 peuvent avoir une structure monocouche ou multicouche.

La couche conductrice 114 est au moins partiellement transparente au rayonnement lumineux provenant de l'écran d'affichage 52. La couche conductrice 114 peut être en un matériau conducteur et transparent, par exemple en oxyde conducteur et transparent ou TCO (acronyme anglais pour Transparent Conductive Oxide), en nanotubes de carbone, en graphène, en un polymère conducteur, en un métal, ou en un mélange ou un alliage d'au moins deux de ces composés. La couche conductrice 114 peut avoir une structure monocouche ou multicouche.

Des exemples de TCO adaptés à la réalisation de la couche conductrice 114 sont l'oxyde d'indium-étain (ITO, de l'anglais Indium Tin Oxide), l'oxyde d'aluminium-zinc (AZO, de l'anglais Aluminium Zinc Oxide) et l'oxyde de gallium-zinc (GZO, de l'anglais Gallium Zinc Oxide). Des exemples de polymères conducteurs adaptés à la réalisation de la couche conductrice 114 sont le polymère connu sous la dénomination PEDOT:PSS, qui est un mélange de poly(3,4)-éthylènedioxythiophène et de polystyrène sulfonate de sodium et la polyaniline, également appelé PAni. Des exemples de métaux adaptés à la réalisation de la couche conductrice 114 sont l'argent (Ag), l'aluminium (Al), l'or (Au), le cuivre (Cu), le nickel (Ni), le titane (Ti) et le chrome (Cr). Un exemple de structure multicouche adaptée à la réalisation de la couche conductrice 114 est une structure multicouche d'AZO et d'argent de type AZO/Ag/AZO.

L'épaisseur de la couche conductrice 114 peut être comprise entre 10 nm et 5 $\mu$m, par exemple de l'ordre de 30 nm. Dans le cas où la couche conductrice 114 est métallique, l'épaisseur de la couche conductrice 114 est inférieure ou égale à 20 nm, de préférence inférieure ou égale à 10 nm.

La couche diélectrique 108 et/ou chaque couche de l'empilement 104 peut être réalisée en polymère fluoré, notamment le polymère fluoré commercialisé sous l'appellation Cytop par la société Bellex, en polyvinylpyrrolidone (PVP), en polyméthacrylate de méthyle (PMMA), en polystyrène (PS), en parylène, en polyimide (PI) ou en un mélange d'au moins deux de ces composés. A titre de variante, la couche diélectrique 108 et/ou chaque couche de l'empilement 104 peut être réalisée en un diélectrique inorganique, notamment en nitrure de silicium (SiN) ou en oxyde de silicium (SiOx). L'épaisseur maximale de chaque couche diélectrique 104, 108 peut être comprise entre 50 nm et 2 $\mu$m, par exemple de l'ordre de 200 nm.

La couche active 112 peut comprendre des petites molécules, des oligomères ou des polymères. Il peut s'agir de matériaux organiques ou inorganiques. La couche active 112 peut comprendre un matériau semiconducteur ambipolaire, ou un mélange d'un matériau semiconducteur de type N et d'un matériau semiconducteur de type P, par exemple sous forme de couches superposées ou d'un mélange intime à l'échelle nanométrique de façon à former une hétérojonction en volume. L'épaisseur de la couche active 112 peut être comprise entre 50 nm et 2 $\mu$m, par exemple de l'ordre de 500 nm.

Des exemples de polymères semiconducteurs de type P adaptés à la réalisation de la couche active 40 sont le poly(3-hexylthiophène) (P3HT), le poly[N-9'-heptadécanyl-2,7-carbazole-alt-5,5-(4,7-di-2-thiényl-2',1',3'-benzothiadiazole)] (PCDTBT), le poly[(4,8-bis-(2-éthylhexyloxy)-benzo[1,2-b;4,5-b'] dithiophène)-2,6-diyl-alt-(4-(2-éthylhexanoyl)-thieno[3,4-b] thiophène))-2,6-diyl] (PBDTTT-C), le poly[2-méthoxy-5-(2-éthyl-hexyloxy)-1,4-phénylène-vinylène] (MEH-PPV) ou le poly[2,6-(4,4-bis-(2-éthylhexyl)-4$H$-cyclopenta [2,1-$b$;3,4-$b$]dithiophène)-$alt$-4,7(2,1,3-benzothiadiazole)] (PCPDTBT).

Des exemples de matériaux semiconducteurs de type N adaptés à la réalisation de la couche active 112 sont les fullerènes, notamment le C60, le [6,6]-phényl-$C_{61}$-butanoate de méthyle ([60]PCBM), le [6,6]-phényl-$C_{71}$-butanoate de méthyle ([70]PCBM), le pérylène diimide, l'oxyde de zinc (ZnO) ou des nanocristaux permettant la formation de boîtes quantiques (en anglais quantum dots).

La couche active 112 peut être interposée entre des première et deuxième couches d'interface, non représentées. La première couche d'interface permet d'aligner le travail de sortie de l'électrode 92 ou 114 avec l'affinité électronique du matériau accepteur utilisé dans la couche active 112. La première couche d'interface peut être réalisée en carbonate de césium (CSCO$_3$), en oxyde métallique, notamment en oxyde de zinc (ZnO), ou en un mélange d'au moins deux de ces composés. La première couche d'interface peut comprendre une couche monomoléculaire auto-assemblée ou un polymère, par exemple du (polyéthyléneimine, polyéthyléneimine éthoxylé, poly[(9,9-bis(3'-(N,N-dimethylamino) propyl)-2,7-fluorene)-alt-2,7-(9,9-dioctylfluorene)]. La deuxième couche d'interface permet d'aligner le travail de sortie de l'autre électrode 92 ou 114 avec le potentiel d'ionisation du matériau donneur utilisé dans la couche active 112. La deuxième couche d'interface peut être réalisée en oxyde de cuivre (CuO), en oxyde de nickel (NiO), en oxyde de vanadium ($V_2O_5$), en oxyde de magnésium (MgO), en oxyde de tungstène ($WO_3$) ou en un mélange d'au moins deux de ces composés. Suivant le mode de polarisation de la photodiode, les couches d'interface facilitent la collection, l'injection ou le blocage des charges depuis les électrodes dans la couche active 112. L'épaisseur de chaque couche d'interface est de préférence comprise entre 0,1 nm et 1 $\mu$m.

La couche adhésive 116 permet la fixation du capteur d'images 14 à l'écran d'affichage 52. La couche adhésive 116 peut être en un matériau diélectrique. La couche adhésive 116 peut avoir une épaisseur comprise entre 1 $\mu$m et 100 $\mu$m, par exemple environ 15 $\mu$m. A titre d'exemple, la couche adhésive 116 correspond à une colle époxy. Selon un autre exemple, la couche adhésive 116 correspond à un adhésif sensible à la pression ou PSA (sigle anglais pour Pressure-Sensitive Adhesive).

La figure 20 est une vue en coupe analogue à la figure 19 d'un autre mode de réalisation plus détaillé du système d'affichage 50 comprenant le capteur d'images 14 représenté en figure 18. Le capteur d'images 14 comprend les mêmes éléments que pour le mode de réalisation représenté en figure 19 à la différence que l'élément de connexion 94 n'est pas en contact direct avec la couche active 112, le capteur d'images 14 comprenant, pour chaque photodétecteur 28, une couche conductrice électriquement 117, jouant le rôle d'électrode inférieure, reposant sur la couche isolante 108 au contact de la couche active 112 et au contact de l'élément de connexion 94 au travers de l'ouverture 110. De façon avantageuse, la surface de contact entre l'électrode inférieure 115 et la couche active 112 peut être supérieure à la surface de contact entre l'élément de connexion 94 et la couche active 112 dans le mode de réalisation représenté en figure 19.

Selon un mode de réalisation, le capteur d'images 14 peut comprendre une couche de protection, par exemple en un matériau diélectrique, interposée entre l'électrode supérieure 114 et la couche adhésive 116.

Selon un mode de réalisation, le capteur d'images 14 peut comprendre des moyens de filtrage du rayonnement incident en fonction de l'incidence du rayonnement par rapport à la couche de protection 18 de l'écran d'affichage 52, notamment pour que chaque photodétecteur 28 reçoive seulement le rayonnement dont l'incidence par rapport à un axe perpendiculaire à la couche de protection 18 de l'écran d'affichage 52 est inférieure à 45°, de préférence inférieure à 30°. Ceci permet, de façon avantageuse, de réduire le bruit du signal fourni par chaque photodétecteur 28. Selon un mode de réalisation, les moyens de filtrage peuvent comprendre un réseau de sténopés (en anglais pinholes) recouvrant le réseau de photodétecteurs 28. Selon un autre mode de réalisation, les moyens de filtrage peuvent comprendre un réseau de lentilles, par exemple des lentilles de Fresnel. Selon un autre mode de réalisation, les moyens de filtrage peuvent comprendre un réseau de fibres optiques dont les axes sont parallèles et orientés de façon sensiblement perpendiculaire à la face 19 de l'écran d'affichage 52, le réseau de fibres optiques recouvrant le réseau de photodétecteurs 28.

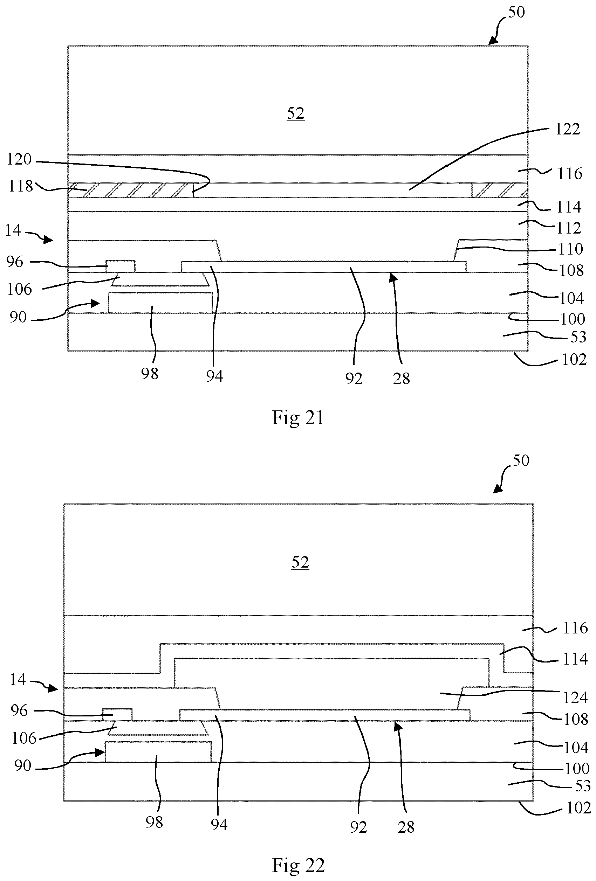

La figure 21 est une vue en coupe analogue à la figure 19 d'un autre mode de réalisation plus détaillé du système d'affichage 50 comprenant le capteur d'images 14 représenté en figure 18. Le capteur d'images 14 comprend les mêmes éléments que pour le mode de réalisation représenté en figure 19 et comprend, en outre, une couche 118 d'un matériau opaque au rayonnement détecté par les photodétecteurs 28 et comprenant, pour chaque photodétecteur 28, une ouverture 120 remplie d'un matériau 122 au moins partiellement transparent au rayonnement détecté par les photodétecteurs 28.

Selon un mode de réalisation, le capteur d'images 14 peut comprendre des moyens de filtrage du rayonnement incident selon la longueur d'onde interposés entre l'écran d'affichage 52 et la couche active 112. Il peut s'agir d'un filtre adapté à laisser passer le rayonnement provenant de l'organe d'actionnement à détecter sur la plage de longueurs d'ondes détectées par les photodétecteurs 28.

La figure 22 est une vue en coupe analogue à la figure 19 d'un autre mode de réalisation plus détaillé du système d'affichage 50 comprenant le capteur d'images 14 représenté en figure 18. Le capteur d'images 14 comprend les mêmes éléments que pour le mode de réalisation représenté en figure 19 à la différence que la couche active 112 est remplacée, pour chaque pixel de détection, par une portion active 124. Ceci permet de supprimer les risques de diaphonie optique qui pourrait être observée avec le mode de réalisation décrit en figure 19. Toutes les portions actives 120 peuvent avoir la même composition que la couche active 112. A titre de variante, les portions actives 120 peuvent avoir des compositions différentes et être adaptées à détecter des rayonnements lumineux à des longueurs d'ondes différentes.

Dans les modes de réalisation décrits précédemment en relation avec les figures 19 à 22, les transistors 90 sont à grille basse (en anglais bottom gâte transistors) dans la mesure où les pistes 98 formant les grilles des transistors 90 sont interposées entre le support 53 et les portions semiconductrices 106. Selon un autre mode de réalisation, les transistors 90 peuvent être des transistors à grille haute (en anglais top gâte transistors) pour lesquels les portions semiconductrices 106 des transistors 90 sont interposées entre le support 53 et les pistes 98 formant les grilles.

Selon un mode de réalisation, le procédé de fabrication du système d'affichage 50 comprend la fabrication de l'écran d'affichage 52, la fabrication du capteur d'images 14 et la fixation du capteur d'images 14 à l'écran d'affichage 52 par la couche adhésive 116.

De façon avantageuse, le procédé de fabrication du système d'affichage 50 permet de réutiliser directement des structures classiques d'écrans d'affichage et/ou de capteurs d'images. En outre, l'écran d'affichage 52 et le capteur d'images 14 étant réalisés de façon séparée, les étapes de fabrication des éléments du capteur d'images n'interfèrent pas avec les étapes de fabrication des éléments de l'écran d'affichage et/ou inversement. En outre, l'écran d'affichage et le capteur d'images peuvent comprendre des composants électroniques de même nature, notamment des transistors, qui peuvent être conçus pour répondre à des contraintes de fonctionnement différentes pour l'écran d'affichage et pour le capteur d'images.

Selon les matériaux considérés, le procédé de formation des couches du capteur d'images 14 peut correspondre à un procédé dit additif, par exemple par impression directe du matériau composant les couches organiques aux emplacements souhaités notamment sous forme de sol-gel, par exemple par impression par jet d'encre, héliographie, sérigraphie, flexographie, revêtement par pulvérisation (en anglais spray coating) ou dépôt de gouttes (en anglais drop-casting). Selon les matériaux considérés, le procédé de formation des couches du capteur d'images 14 peut correspondre à un procédé dit soustractif, dans lequel le matériau composant les couches organiques est déposé sur la totalité de la structure et dans lequel les portions non utilisées sont ensuite retirées, par exemple par photolithographie ou ablation laser. En outre, selon les couches et les matériaux considérés, le matériau composant les couches organiques est déposé sur la totalité de la structure et peut ne pas être retiré, le pas des photodétecteurs 28 étant alors obtenu par la position des électrodes 92. Selon le matériau considéré, le dépôt sur la totalité de la structure peut être réalisé par exemple par voie liquide, par pulvérisation cathodique ou par évaporation. Il peut s'agir notamment de procédés du type dépôt à la tournette, revêtement par pulvérisation, héliographie, revêtement par filière (en anglais slot-die coating), revêtement à la lame (en anglais blade-coating), flexographie ou sérigraphie. Lorsque les couches sont métalliques, le métal est, par exemple, déposé par évaporation ou par pulvérisation cathodique sur l'ensemble du support et les couches métalliques sont délimitées par gravure.

De façon avantageuse, au moins certaines des couches du capteur d'images 14 peuvent être réalisées par des techniques d'impression. Les matériaux de ces couches décrites précédemment peuvent être déposés sous forme liquide, par exemple sous forme d'encres conductrices et semiconductrices à l'aide d'imprimantes à jet d'encre. Par matériaux sous forme liquide, on entend ici également des matériaux en gel déposables par des techniques d'impression. Des étapes de recuit sont éventuellement prévues entre les dépôts des différentes couches, mais les températures de recuit peuvent ne pas dépasser 150°C, et le dépôt et les éventuels recuits peuvent être réalisés à la pression atmosphérique.

Des modes de réalisation particuliers ont été décrits. Diverses variantes et modifications apparaissent à l'homme de l'art. En particulier, le filtre angulaire 16 décrit précédemment peut en outre servir à collimater le rayonnement qui le traverse. En outre, le filtre angulaire peut servir de filtre polariseur, le filtre étant formé par perforation d'un film polariseur ou étant formé sur une couche polarisante. Lorsque le rayonnement atteignant le filtre angulaire est polarisé, par exemple linéairement, la direction de polarisation du film polariseur est choisie différente de la direction de polarisation du rayonnement de sorte que le rayonnement est sensiblement bloqué par le film polariseur. En outre, bien que dans des modes de réalisation décrits précédemment, un transistor à effet de champ soit associé à chaque composant électroluminescent, il est clair que deux ou plus de deux transistors à effet de champ peuvent être associés à chaque composant électroluminescent. De façon analogue, bien que dans des modes de réalisation décrits précédemment, un transistor à effet de champ soit associé à chaque photodétecteur du capteur d'images, il est clair que deux ou plus de deux transistors à effet de champ peuvent être associés à chaque photodétecteur. Divers modes de réalisation avec diverses variantes ont été décrits ci-dessus. On note que l'homme de l'art peut combiner divers éléments de ces divers modes de réalisation et variantes sans faire preuve d'activité inventive. En particulier, les filtres angulaires décrits en relation avec les figures 10 à 17 peuvent être mis en oeuvre avec le système d'acquisition d'images 10 représenté sur la figure 1, le système d'acquisition d'images 25 représenté sur la figure 2, le système d'acquisition d'images 40 représenté sur la figure 4 ou le système d'affichage représenté sur la figure 7. En outre, la couche de filtrage 118 décrite en relation avec la figure 21 peut être également utilisée avec les modes de réalisation décrits en relation avec les figures 20 et 22.

**Revendications**

1.  Système d'acquisition d'images (50) comprenant :

    - une source (22 ; 42) d'un rayonnement (44) ;
    - un écran d'affichage (52), la source étant confondue avec l'écran d'affichage ou étant distincte de l'écran d'affichage ; et, dans l'ordre :

- un filtre angulaire (118) ;
- une couche (114) au moins partiellement transparente audit rayonnement ; et
- un capteur d'images (14) comprenant une matrice de photodétecteurs (28) adaptés à détecter ledit rayonnement et comprenant une première face,

le filtre angulaire étant adapté à bloquer les rayons dudit rayonnement dont l'incidence par rapport à une direction orthogonale à la première face est supérieure à un seuil et à laisser passer des rayons dudit rayonnement dont l'incidence par rapport à une direction orthogonale à la première face est inférieure au seuil, et étant constitué d'un matériau opaque au rayonnement détecté par les photodétecteurs et comprenant, pour chaque photodétecteur, une ouverture (120) remplie d'un matériau (122) au moins partiellement transparent au rayonnement détecté par les photodétecteurs.

2. Système selon la revendication 1, comprenant en outre des moyens de filtrage du rayonnement selon la longueur d'onde, entre l'écran d'affichage (52) et une couche active (112) du capteur d'image (14).

3. Système selon la revendication 1 ou 2, dans lequel ladite couche (114), au moins partiellement transparente audit rayonnement, est une couche électriquement conductrice.

4. Système d'acquisition d'images selon l'une quelconque des revendications 1 à 3, dans lequel le rayonnement (44) est dans le domaine visible et/ou dans le domaine infrarouge.

5. Système d'acquisition d'images selon l'une quelconque des revendications 1 à 4, dans lequel, pour chaque ouverture (64, 120), le rapport entre la hauteur de l'ouverture, mesurée perpendiculairement à la première face (15), et la largeur de l'ouverture, mesurée parallèlement à la première face, varie de 1 à 10.

6. Système d'acquisition d'images selon l'une quelconque des revendications 1 à 5, comprenant, en outre, des lentilles (70) recouvrant les ouverture (64, 120).

7. Système d'acquisition d'images selon l'une quelconque des revendications 1 à 6, dans lequel les photodétecteurs (28) comprennent des photodiodes organiques.

8. Système d'affichage selon l'une quelconque des revendications 1 à 7, dans lequel l'écran d'affichage (52) comprend une matrice de composants électroluminescents (56), dans lequel les composants électroluminescents sont au moins en partie transparents au rayonnement (44) et dans lequel les composants électroluminescents sont situés au moins en partie en regard des photodétecteurs (28) selon une direction perpendiculaire à la première face (15).

9. Système d'affichage selon la revendication 8, dans lequel les composants électro-luminescents (56) comprennent des diodes électroluminescentes organiques.

10. Système d'affichage selon la revendication 8 ou 9, dans lequel le capteur d'images (14) comprend un filtre du rayonnement émis par les composants électroluminescents (56) en fonction de la longueur d'onde entre la matrice de photodétecteurs (28) et l'écran d'affichage (52).

11. Système d'affichage selon l'une quelconque des revendications 1 à 10, dans lequel le capteur d'images (14) comprend un élément de sélection (90) pour chaque photodétecteur (28), les photodétecteurs étant situés entre les éléments de sélection (90) et l'écran d'affichage (52).

12. Utilisation du système d'affichage (10) selon l'une quelconque des revendications 1 à 11 pour la détection d'au moins une empreinte digitale d'un utilisateur.

13. Procédé de fabrication d'un système d'acquisition d'images, comprenant les étapes suivantes :

   - fournir une source (22 ; 42) d'un rayonnement (44) et un écran d'affichage (52), la source étant confondue avec l'écran d'affichage ou étant distincte de l'écran d'affichage ;
   - former un capteur d'images (14) comprenant une matrice de photodétecteurs (28) adaptés à détecter ledit rayonnement ;
   - former une couche (114) au moins partiellement transparente audit rayonnement ; et
   - former, sur la couche au moins partiellement transparente, un filtre angulaire (118), recouvrant le capteur d'images, et adapté à bloquer les rayons dudit rayonnement dont l'incidence par rapport à une direction orthogonale à la face est supérieure à un seuil et à laisser passer des rayons dudit rayonnement dont l'incidence par rapport à une direction orthogonale à la face est inférieure au seuil, le filtre angulaire étant constitué d'un matériau opaque au rayonnement détecté par les photodétecteurs et comprenant, pour chaque photodétecteur, une ouverture (120) remplie d'un matériau (122) au moins partiellement transparent au rayonnement détecté par les photodétecteurs.

**14.** Procédé selon la revendication 13, dans lequel la formation du filtre angulaire (118) comprend les étapes suivantes :

former une couche d'une résine photosensible ; et
former les murs par gravure de la couche par photolithographie.

**15.** Procédé selon la revendication 14, dans lequel la résine photosensible est une résine noire ou colorée.

Fig 1

Fig 2

Fig 3

Fig 4

Fig 5

Fig 6

Fig 7

Fig 8A

Fig 8B

Fig 9

Fig 10

Fig 11

Fig 12

Fig 13

Fig 14

Fig 15

Fig 16

Fig 17

Fig 18

Fig 19

Fig 20

Fig 21

Fig 22

Europäisches
Patentamt

European
Patent Office

Office européen
des brevets

# RAPPORT DE RECHERCHE EUROPEENNE

Numéro de la demande

EP 22 20 5316

## DOCUMENTS CONSIDERES COMME PERTINENTS

| Catégorie | Citation du document avec indication, en cas de besoin, des parties pertinentes | Revendication concernée | CLASSEMENT DE LA DEMANDE (IPC) |
|---|---|---|---|
| X | US 2016/328595 A1 (SUN CHING-CHERNG [TW] ET AL) 10 novembre 2016 (2016-11-10) | 1,4, 12-15 | INV.<br>G09G3/32 |
| Y | * abrégé * | 2,3,6-10 | G06K9/00 |
| A | * alinéas [0009], [0010], [0059], [0064], [0065], [0066] *<br>----- | 5,11 | G06F3/042<br>H01L27/146<br>G06F3/041 |
| Y | US 2010/264297 A1 (KURAHASHI HAJIME [JP]) 21 octobre 2010 (2010-10-21)<br>* abrégé *<br>* alinéas [0008], [0009], [0017] *<br>----- | 2,6,10 | G09G3/3208<br>H01L27/32<br>H01L27/30<br>G06V10/10<br>G06V40/12 |
| Y | US 2014/218327 A1 (SHI WEIDONG [US] ET AL) 7 août 2014 (2014-08-07)<br>* abrégé *<br>* alinéas [0028], [0042] *<br>----- | 3,8-10 | G06V40/13 |
| Y | EP 3 048 562 A1 (COMMISSARIAT ENERGIE ATOMIQUE [FR]; ISORG [FR]) 27 juillet 2016 (2016-07-27)<br>* abrégé *<br>* alinéa [0022] *<br>----- | 7 | |

**DOMAINES TECHNIQUES RECHERCHES (IPC)**

G09G
H01L
G06F
G06K
G01K
G06V

Le présent rapport a été établi pour toutes les revendications

| Lieu de la recherche | Date d'achèvement de la recherche | Examinateur |
|---|---|---|
| Munich | 14 décembre 2022 | Lauri, Lauro |

CATEGORIE DES DOCUMENTS CITES

X : particulièrement pertinent à lui seul
Y : particulièrement pertinent en combinaison avec un autre document de la même catégorie
A : arrière-plan technologique
O : divulgation non-écrite
P : document intercalaire

T : théorie ou principe à la base de l'invention
E : document de brevet antérieur, mais publié à la date de dépôt ou après cette date
D : cité dans la demande
L : cité pour d'autres raisons
.....................................................................
& : membre de la même famille, document correspondant

EPO FORM 1503 03.82 (P04C02)

# EP 4 148 718 A1

## ANNEXE AU RAPPORT DE RECHERCHE EUROPEENNE
## RELATIF A LA DEMANDE DE BREVET EUROPEEN NO.

EP 22 20 5316

14-12-2022

| Document brevet cité au rapport de recherche | Date de publication | Membre(s) de la famille de brevet(s) | Date de publication |
|---|---|---|---|
| US 2016328595 A1 | 10-11-2016 | CN 106127102 A<br>TW 201640418 A<br>US 2016328595 A1 | 16-11-2016<br>16-11-2016<br>10-11-2016 |
| US 2010264297 A1 | 21-10-2010 | JP 5435996 B2<br>JP 2010225904 A<br>US 2010264297 A1 | 05-03-2014<br>07-10-2010<br>21-10-2010 |
| US 2014218327 A1 | 07-08-2014 | AUCUN | |
| EP 3048562 A1 | 27-07-2016 | EP 3048562 A1<br>FR 3032042 A1<br>US 2016219196 A1 | 27-07-2016<br>29-07-2016<br>28-07-2016 |

EPO FORM P0460

**EP 4 148 718 A1**

## RÉFÉRENCES CITÉES DANS LA DESCRIPTION

### Documents brevets cités dans la description

- FR 1751789

- FR 1757669